## Europäisches Patentamt

## European Patent Office

## Office européen des brevets

(19)

(11) Veröffentlichungsnummer: **0 004 289**
**B1**

(12) **EUROPÄISCHE PATENTSCHRIFT**

(45) Veröffentlichungstag der Patentschrift:
16.12.81

(51) Int. Cl.³: **H 01 L 21/60, H 01 L 23/48**

(21) Anmeldenummer: **79100543.2**

(22) Anmeldetag: **23.02.79**

(54) **Verfahren zum Verbinden einer ersten integrierten Schaltungsvorrichtung mit einer Anzahl von Verbindungspunkten mit einer zweiten integrierten Schaltungsvorrichtung.**

(30) Priorität: **27.03.78 US 890445**

(43) Veröffentlichungstag der Anmeldung:
**03.10.79 Patentblatt 79/20**

(45) Bekanntmachung des Hinweises auf die Patenterteilung:
**16.12.81 Patentblatt 81/50**

(84) Benannte Vertragsstaaten:
**DE FR GB**

(56) Entgegenhaltungen:
**DE-A-1 954 135**
**US-A-3 517 278**
**US-A-3 993 515**
**US-A-4 078 980**
**IBM TECHNICAL DISCLOSURE BULLETIN,**
**Vol. 20, Okt. 1977, N. y.**
**A. J. FERRARO et al.: »Joint reliability using a plated copper stud, Seite 1722**

(73) Patentinhaber: **International Business Machines Corporation, Armonk, N.Y. 10504 (US)**

(72) Erfinder: **Joshi, Kailash Chandra, 963 South Pines Drive, Endwell, New York 13760 (US)**
Erfinder: **Spaight, Ronald Neil, 309 Burd Drive, Vestal, New York 13850 (US)**

(74) Vertreter: **Kirchhof, Norbert, Ing. grad., Schönaicher Strasse 220, D-7030 Böblingen (DE)**

## Verfahren zum Verbinden einer ersten integrierten Schaltungsvorrichtung mit einer Anzahl von Verbindungspunkten mit einer zweiten integrierten Schaltungsvorrichtung

Die Erfindung bezieht sich auf ein Verfahren zum Verbinden einer ersten integrierten Schaltungsvorrichtung mit einer Anzahl von Verbindungspunkten mit einer zweiten integrierten Schaltungsvorrichtung, die eine ähnliche Anzahl von Verbindungspuffern aufweist, wobei beide Vorrichtungen ungefähr die gleiche thermische Ausdehnungscharakteristik aufweisen.

Mit dem Aufkommen räumlich ausgedehnter integrierter Schaltungstechnologien werden kontinuierlich größere Anforderungen an die Chipbefestigungstechniken gestellt. Eine weitere Komplizierung erfahren diese Techniken durch die Zunahme des Integrationsniveaus, wobei die Chipeingangs/ausgangsanforderungen zunehmen und die Gesamtchipgröße und die Energieverteilung der Packung verbessert werden. Ferner treten bei vielen Anwendungen große Temperaturabweichungen auf, weshalb ein Substrat erforderlich ist, das der thermischen Ausdehnungscharakteristik der Vorrichtung sehr nahe kommt. Die Josephson-Technologie ist ein Beispiel, bei dem passende Ausdehnungsträger (MEC) und zugehörige Packungstechniken, die bei Tiefsttemperaturen arbeiten müssen, erforderlich sind. Die bestehenden und sich in Entwicklung befindlichen Schaltungstechniken für Großintegration und die betrachteten Josephson-Anforderungen können verbessert werden durch Verwendung einer entsprechenden Expansionsträgertechnologie für die Chip- und Modulepackung.

Eine gegenwärtige Methode der Chipbefestigung stellt Anforderungen an das Positionieren von Lötmittelkugeln auf der Basis eines integrierten Schaltungschips. Diese Lötmittelkugeln werden dann schließlich wieder flüssig, nachdem das Chip auf dem Träger in die richtige Lage gebracht wurde, wobei diese Lötmittelkugeln eine Verbindung zwischen dem Chip und dem Träger herstellen. Während dieses Verfahren bei früheren integrierten Schaltungstechnologien vorteilhaft war, wegen der kleinen Chipgröße, den thermischen Begrenzungen und der Nachbearbeitkeit, werden die künftigen Verwendungsmöglichkeiten begrenzt. Außerdem ruft die Verwendung einer solchen Technologie mit einem Chip und einem Träger, die keine abgestimmten Ausdehnungscharakteristiken aufweisen, beträchtliche Spannungen in den Lötmittelkugelverbindungen dar, da Temperaturschwankungen auftreten, wodurch die Gesamtzuverlässigkeit der Packung vermindert wird. Solch eine Lötmittelkugeltechnologie ist in den US-Patentschriften 3 577 037 und 3 827 918 beschrieben.

Ein anderes Verfahren zur Herstellung von Verbindungskomponenten ist in der US-Patentschrift 3 292 240 beschrieben. Hierbei enthält das Substrat oder der Träger auf der Oberfläche geeignete Schaltungen, die mit der Unterseite von Stiften verbunden sind, welche die endgültigen Verbindungen bilden werden. Anschließend wird eine Chipvorrichtung mit einem metallüberzogenen Streifen auf dem Substrat verbunden. Um jedoch dies zu erreichen sind geeignete Kontakte von sphärischer Form erforderlich. Genau wie bei der zuvor beschriebenen Lötmittelkugeltechnologie verwenden diese sphärischen Kugeln einen Zwischenraum und darüber hinaus erfordert die Befestigungstechnik ein Einpressen der sphärischen Kugeln in das Muster auf der Oberfläche des Substrats.

Aus der Zeitschrift IBM TDB, Vol. 20, Oktober 1977, Seite 1722 ist ein Verfahren zum Verbinden einer ersten integrierten Schaltungsvorrichtung mit einer Anzahl von Verbindungspunkten mit einer zweiten integrierten Schaltungsvorrichtung, die eine ähnliche Anzahl von Verbindungspunkten aufweist, bekannt, bei dem an jedem der Verbindungspunkte der ersten integrierten Schaltungsvorrichtung metallische Stifte vorgesehen werden.

Aus der US-A-3 993 515 ist es bekannt, einen zur Kontaktierung eines Halbleiterchips geeigneten Kupferstift herzustellen durch Niederschlagen einer dünnen Schicht eines leitenden Metalles, auf den Bereichen, in denen diese Stifte gebildet werden sollen, daß aus der ersten Vorrichtung eine Schicht eines Fotoresists niedergeschlagen wird, die belichtet und entwickelt wird, um die Stiftbereiche auf der Oberfläche zu definieren, und daß in diesen definierten Bereichen des Fotoresists Kupfer elektroplattiert wird und anschließend der Fotoresist entfernt wird.

Die im kennzeichnenden Teil des Anspruchs 6 enthaltenen Merkmale sind aus der DE-A-1 954 135 bekannt.

Die Erfindung, wie sie in den Ansprüchen gekennzeichnet ist, löst die Aufgabe, ein Befestigungsverfahren anzugeben, bei dem die Ausdehnung der Chips und des Trägers weitgehend aufeinander abgestimmt sind, wodurch das Verfahren zuverlässig und wiederholbar ist und auch die thermische Charakteristik der Zwischenverbindungen bei Aufrechterhaltung der Dichte der Verbindungspunkte verbessert.

Die durch die Erfindung erreichten Vorteile sind im wesentlichen darin zu sehen, daß die thermische Leistungsfähigkeit wesentlich verbessert wird durch Verminderung des Wärmewiderstandes des Chipbefestigungsweges um 50% oder mehr. Zusätzlich ist es möglich, gebrauchte Chips zu ersetzen und Chips mit einer potentiell höheren Eingangs/Ausgangsdichte zu verwenden infolge der kleineren räumlichen Größe der Stifte im Vergleich zu den Lötmittelkugelverbindungen des Standes der Technik. Ferner ist ein Verbinden von Chips bei niedrigen Temperaturen flußfrei möglich für fortschrittliche Anwendungen wie der Josephson-Technologie. Außerdem ist die der erfindungsgemäßen Verbindung eigene Zuverlässigkeit sehr hoch, da die miteinander verbundenen Teile sich beinahe gleichmäßig während thermischer Zyklen ausdehnen. Deshalb können große Chips mit einem Chipträger verbunden werden, ohne die Zuverlässigkeit der Gesamtpackung zu beeinträchtigen. Aus den gleichen Gründen können viele Chips mit dem gleichen Modul austauschbar verbunden werden mit einer ausgezeichneten Nacharbeitbarkeit defekter Einheiten.

Im folgenden wird die Erfindung anhand eines in den Figuren veranschaulichten Ausführungsbeispieles beschrieben.

Es zeigt

Fig. 1 einen Teil eines Substrates mit Stiften, die mit den Chipanschlußstellen zu verbinden sind, in auseinandergezogener, schaubildlicher Darstellung und

Fig. 2 einen Schnitt des Schaltungssubstrates, durch mit demselben verbundene Leitungen und durch einen Stift und ein Chip.

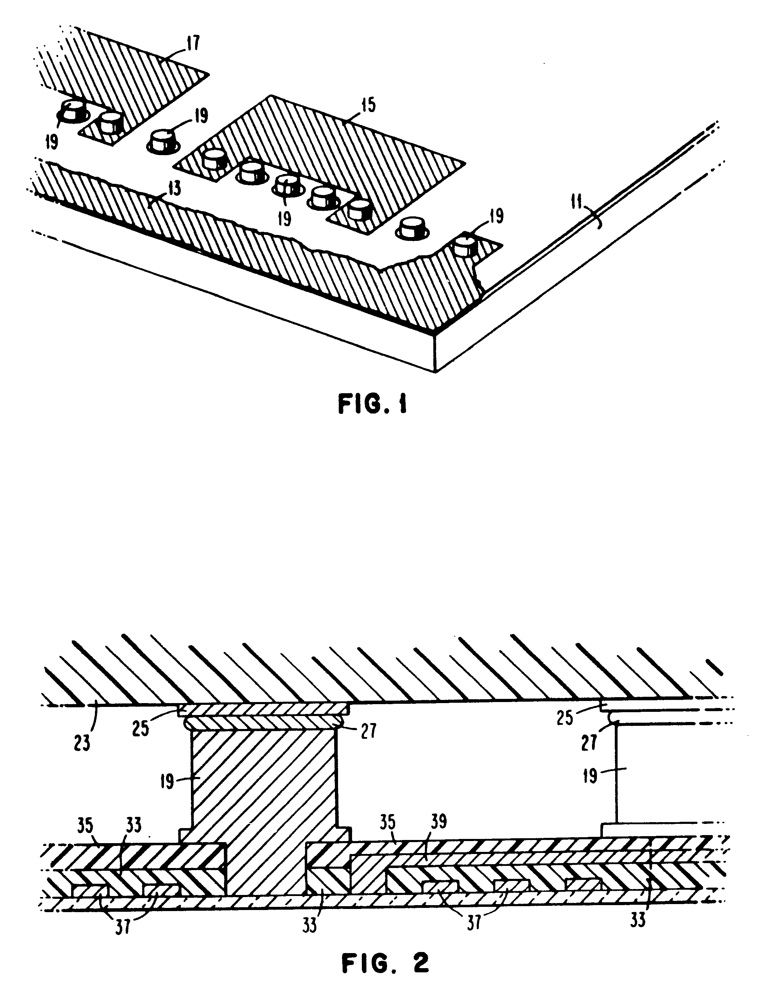

In Fig. 1 ist ein Trägerteil einer kompletten Einheit gezeigt, die einen Siliziumträger 11 mit entsprechender Ausdehnung für Siliziumvorrichtungen aufweist, auf dem sich die Grundleitungsmuster 13, 15, 17 befinden. Das Trägermaterial könnte, ohne darauf begrenzt zu sein, Siliziumdioxyd oder Polyamid einschließen. Typischerweise bestehen die Leitermuster aus Kupfer und sind mittels üblicher Metallniederschlags- oder Ätztechniken hergestellt. Nachdem die Leitermuster auf der Oberfläche des Siliziumträgers 11 gebildet sind, wird eine Mehrzahl von Stiften 19 auf der Oberfläche gebildet, und zwar in einem Muster, das mit den Anschlußmetallfüßen des Chips, die mit dem Substrat zu verbinden sind, übereinstimmt. In einem bevorzugten Ausführungsbeispiel werden die Kupferstifte auf dem Siliziumträger 11 durch Elektroplattieren von Kupfer von geeigneter Höhe mittels einer geeigneten Maske gebildet. Eine typische Stifthöhe beträgt 8 bis $12 \times 10^{-3}$ cm bei einem Durchmesser von 6 bis $9 \times 10^{-3}$ cm. Nachdem die Stifte erstellt sind, ist die Maske zu entfernen und ist der Siliziumträger 11 für die Aufnahme der Chips vorbereitet.

Die Befestigung der Chips auf dem Siliziumträger 11 ist in Fig. 2 dargestellt. Das Chip 23 enthält eine Mehrzahl von Puffern 25, die mit den entsprechenden Stiften 19 des Siliziumträgers 11 zu verbinden sind. Die Puffer 25 bestehen aus Metall und befinden sich an der Unterseite des Chip 23. Zwischen den Puffern 25 und den Kupferstiften 19 befindet sich eine kleine Menge von Lötmittel 27, das der Vervollständigung der Verbindung zwischen den Stiften und den Puffern dient. Das Lötmittel ist nur notwendig für die Herstellung der Verbindung und um eine geringfügige planare Verschiedenheit zwischen dem Chip und dem Träger herzustellen, so daß die Dicke des Lötmittels voraussichtlich geringer ist oder gleich $4 \times 10^{-3}$ cm.

Bei Verwendung der vorstehenden Techniken ist eine geringe Höhe zwischen dem Chip und dem Träger erforderlich, wodurch mit wenig Lötmittel eine beträchtliche Zunahme der Wärmeleitfähigkeit erzielt wird. Der Gewinn liegt bei einer Reduzierung des Wärmewiderstandes zwischen dem Chip und dem Substrat um 50% und mehr.

Der Träger kann ein- oder vielschichtig ausgebildet sein. Bei einer einschichtigen Ausbildung (Fig. 1) sind die Leitungsmuster 13, 15, 17 auf der Oberfläche des Trägers gebildet. Bei einer vielschichtigen Ausführung enthält der Träger eine Mehrzahl von inneren Schichten. So enthält der Träger (Fig. 2) erste und zweite Schichten 33, 35, die eine X-Drahtebene 37 und eine Y-Drahtebene 39 umfassen. Dies sind im Grunde elektrische Leiterinnenebenen, die in geeignetem dielektrischen Material eingeschlossen sind, z. B. Polyamid oder Quarz und aufeinanderfolgend in einem Metallniederschlag- und Ätzverfahren aufgebracht sind, um die gewünschten Zwischenverbindungen zu bilden. Zusätzlich kann die vielschichtige Pakkung ein oder mehrere Signal- und Grundebenen enthalten.

Während der Bearbeitung der Chips für solch eine Trägerpackung sind die Chips bis einschließlich der Metallanwendung (vor dem Aufdampfen des Lötmittels) normal zu bearbeiten. Als nächstes werden die Anschlußbereiche mit einem geeigneten Lötmittel verzinnt und bilden dadurch die sogenannten Anschlußmetallfüße des Chips. Die Kupferstifte 19 von geeigneter Höhe sind auf dem Träger 11 in einem Muster plaziert, um den Verbindungspuffern auf dem Chip 23 zu entsprechen. Hierauf wird das Chip mit den Stiften auf dem Träger ausgerichtet und ein Lötmittelwiederfluß findet statt, um die beiden Teile miteinander zu verbinden.

Eine Methode für die Herstellung der Stifte auf dem Träger (oder Chip) besteht darin, zunächst auf der Oberfläche desselben einen Überzug aus leitendem Material (Kupfer) schnell aufzubringen. Dann wird das Stiftmuster durch Verwendung eines üblichen Photoresists gebildet, der aufgebracht belichtet und entwickelt wird, wodurch das Stiftmuster auf der Oberfläche definiert ist. Dann werden zusätzlich die Kupferstifte auf den belichteten, schnell gebildeten Überzug in den durch den Photoresist definierten Bereichen plaziert, worauf der Photoresist entfernt wird und die Oberfläche des Trägers (oder Chips) schnell geätzt wird, um den überschüssigen Überzug zu entfernen. Natürlich könnten die Stifte auch unter Verwendung eines anderen Plattierungsverfahrens hergestellt werden, das Aufsprühen durch eine Molybdänmaske vorsieht oder durch Verwendung üblicher additiver oder subtraktiver Verfahren. Bei einem additiven Plattierungsverfahren kann es notwendig sein, die Plattierungslösung aufzurühren (beispielsweise durch Ultraschall), um sicherzustellen, daß in den definierten Stiftbereichen die volle Stärke der Lösung zur Verfügung steht.

Bei besonderen Verwendungen, wie bei der Josephson-Technologie, erfordert die Chipbefestigung ein flußfreies Verbinden bei einer Temperatur unter 60°C. Die Stiftbefestigungstechnik der vorliegenden Erfindung ist besonders geeignet für solche Anwendungen, da der Stift leicht metallurgische Verbindungen eingehen kann durch Verwendung eines geringen Druckes ohne Fluß bei relativ niedrigen Temperaturen. Geeignete Metalle können für die Stifte und Lötmittelzusammensetzungen verwendet werden, um die notwendige Supraleitfähigkeit dieser Verbindungen herzustellen.

## Patentansprüche

1. Verfahren zum Verbinden einer ersten integrierten Schaltungsvorrichtung (11) mit einer Anzahl von Verbindungspunkten mit einer zweiten integrierten Schaltungsvorrichtung (23), die eine ähnliche Anzahl von Verbindungspuffern (25) aufweist, wobei beide Vorrichtungen ungefähr die gleiche thermische Ausdehnungscharakteristik aufweisen, dadurch gekennzeichnet, daß an jedem der Verbindungspunkte der ersten integrierten Schaltungsvorrichtung (11) metallische Stifte (19) vorgesehen werden, deren freie Enden eine verbindungsfähige, plane Oberfläche aufweisen, daß Lötmittel (27) in einer Höhe von etwa kleiner oder gleich $4 \cdot 10^{-3}$ cm auf die plane Oberfläche jedes Verbindungspuffers (25) der zweiten integrierten Schaltungsvorrichtung (23) aufgebracht wird, daß die beiden integrierten Schaltungsvorrichtungen (11, 23) ausgerichtet werden, so daß jeder metallische Stift (19) der einen Vorrichtung (11) mit dem entsprechenden Verbindungspuffer (25) der zweiten Vorrichtung (23) ausgerichtet ist und daß auf die Stifte (19) und Verbindungspuffer (25) ein ausreichender Druck und Temperatur ausgeübt werden, um jeden der Stifte mit dem zugeordneten Verbindungspuffer zu verbinden.

2. Verfahren nach Anspruch 1, dadurch gekennzeichnet, daß die beiden integrierten Schaltungsvorrichtungen ein Halbleiterschaltungschip (23) und einen Chipträger (11) mit einer angepaßten Ausdehnungscharakteristik darstellen.

3. Verfahren nach Anspruch 2, dadurch gekennzeichnet, daß die beiden integrierten Schaltungsvorrichtungen (11, 23) auf Silizium basieren.

4. Verfahren nach Anspruch 1, dadurch gekennzeichnet, daß die Stifte (19) aus Kupfer bestehen.

5. Verfahren nach Anspruch 4, dadurch gekennzeichnet, daß die Kupferstifte (19) hergestellt werden durch Niederschlagen einer dünnen Schicht eines leitenden Metalles auf den Bereichen, in denen diese Stifte gebildet werden sollen, daß auf der ersten Vorrichtung (11) eine Schicht eines Photoresists niedergeschlagen wird, die belichtet und entwickelt wird, um die Stiftbereiche auf der Oberfläche zu definieren, daß in diesen definierten Bereichen des Photoresists Kupfer elektroplattiert wird und anschließend der Photoresist entfernt wird und daß ein Blitzätzen der Oberfläche der ersten Vorrichtun (11) erfolgt, um die belichtete dünne Schich leitenden Metalles davon zu entfernen.

6. Verfahren nach Anspruch 1, dadurc gekennzeichnet, daß die Stifte (19) durc Aufdampfen eines Metalles durch Öffnunger die in einer über der Oberfläche der erste Vorrichtung (11) angeordneten Lehre sich befin den, hergestellt werden, wobei diese Öffnunge mit den Stiftorten übereinstimmen.

7. Verfahren nach Anspruch 6, dadurc gekennzeichnet, daß die Stifte (19) eine zylindri sche Form aufweisen bei einer Höhe von 8 bi $12 \times 10^{-3}$ cm und einem Durchmesser von 6 bi $9 \times 10^{-3}$ cm.

## Claims

1. Method for bonding a first integrated circui device (11) having a number of connecting point to a second integrated circuit device (23) havinç a like number of connecting pads (25), both the first and second devices having approximatel\ equal thermal expansion characteristics, the method being chracterised in that a metal stuc (19) is provided at each of said connecting point of the first integrated circuit device (11), the free top of each stud providing a planar bondablε surface; that a small amount of solder (27), les: than or equal to $4 \times 10^{-3}$ cm in height, is appliec to each connecting pad (25) of the second circuii device (23); that the first and second circuii devices (11, 23) are aligned so that each meta stud (19) of the first device (11) is registered with the respective connecting pad (25) of the second device (23), and that sufficient pressure and temperature are applied to the studs (19) and connecting pads (25) to bond each stud to the respective connecting pad.

2. Method as in claim 1, characterised in that the two integrated circuit devices are a semiconductor circuit chip (23) and a matched expansion characteristics chip carrier substrate (11).

3. Method as in claim 2, characterised in that both integrated circuit devices (11, 23) are based on silicon.

4. Method as in claim 1, characterised in that the studs (19) consist of copper.

5. Method as in claim 4, characterised in that the fabrication of the copper studs (19) comprises depositing a thin layer of conductive metal over the areas encompassing the positions for each stud depositing and subsequent exposing and developing a layer of photoresist on the first device (11) to define the stud areas on the surface of this device, electroplating copper in the stud areas defined in the photoresist subsequent removing the photoresist and flash etching the surface of the first device (11) to remove the exposed thin layer of conductive metal therefrom.

6. Method as in claim 1, characterised in that the metal studs (19) are fabricated by evaporating metal through openings in a pattern mask placed over the surface of the first device (11), said openings corresponding to the stud locations.

7. Method as in claim 6, characterised in that the studs (19) are of cylindrical shape having a height of 8 to $12 \times 10^{-3}$ centimeters and a diameter of 6 to $9 \times 10^{-3}$ centimeters.


**Revendications**

1. Procédé pour lier un premier dispositif à circuits intégrés (11) ayant une pluralité de points de connexion à un second dispositif à circuits intégrés (23) ayant un nombre similaire de contacts (25), les deux dispositifs ayant environ la même caractéristique d'expansion thermique, procédé caractérisé en ce que chacun des points de connexion du premier dispositif à circuits intégrés (11) comprend des plots métalliques (19) dont les extrémités libres comportent une surface plane pouvant être liée,

en ce que l'on dépose de la soudure (27), ayant une épaisseur approximativement inférieure ou égale à $4 \times 10^{-3}$ cm, sur la surface plane de chaque contact (25) du second dispositif à circuits intégrés (23);

en ce que l'on aligne les deux dispositifs à circuits intégrés (11, 23) de telle sorte que chaque plot métallique (19) du premier dispositif (11) est aligné avec le contact correspondant (25) du second dispositif (23), et en ce que les plots (19) et les contacts (25) sont soumis à une pression et une température suffisantes pur lier chacun des plots avec le contact qui lui est associé.

2. Procédé selon la revendication 1, caractérisé en ce que les deux dispositifs à circuits intégrés constituent une microplaquette semi-conductrice (23) et un support de microplaquettes (11) ayant des caractéristiques d'expansions semblables.

3. Procédé selon la revendication 2, caractérisé en ce que les deux dispositifs à circuits intégrés (11, 23) sont à base de silicium.

4. Procédé selon la revendication 1, caractérisé en ce que les plots (19) sont en cuivre.

5. Procédé selon la revendication 4, caractérisé en ce que on réalise les plots de cuivre (19) en déposant une couche mince d'un métal conducteur sur les régions prévues pour la formation de ces plots,

on dépose sur le premier dispositif (11) une couche d'une résine photosensible qui est exposée et développée afin de définir les régions de plots sur la surface,

on dépose du cuivre par électroplacage dans ces régions définies de la résine photosensible qui est ensuite enlevée, et

on procède à un décapage rapide de la surface du premier dispositif (11) afin d'enlever de celle-ci la couche mince exposée de métal conducteur.

6. Procédé selon la revendication 1, caractérisé en ce que l'on produit les plots (19) par évaporation d'un métal à travers les ouvertures d'une configuration disposée sur la surface du premier dispositif (11), ces ouvertures correspondant aux emplacements des plots.

7. Procédé selon la revendication 6, caractérisé en ce que les plots (19) ont une forme cylindrique et une hauteur de 8 à $12 \times 10^{-3}$ centimètres et un diamètre de 6 à $9 \times 10^{-3}$ centimètres.

FIG. 1

FIG. 2